(19) Europäisches Patentamt
European Patent Office
Office européen des brevets

(11) **EP 3 881 088 B1**

(12) **EUROPÄISCHE PATENTSCHRIFT**

(45) Veröffentlichungstag und Bekanntmachung des Hinweises auf die Patenterteilung:
**03.08.2022 Patentblatt 2022/31**

(21) Anmeldenummer: **20789558.2**

(22) Anmeldetag: **07.10.2020**

(51) Internationale Patentklassifikation (IPC):
**G01R 33/31** (2006.01)  **G01N 24/08** (2006.01)

(52) Gemeinsame Patentklassifikation (CPC):
**G01R 33/31; G01N 24/08**

(86) Internationale Anmeldenummer:
**PCT/EP2020/078144**

(87) Internationale Veröffentlichungsnummer:
**WO 2021/073983 (22.04.2021 Gazette 2021/16)**

(54) **TEMPERIERUNG FÜR EIN NMR-PROBENRÖHRCHEN**

CONTROLLING THE TEMPERATURE OF AN NMR SAMPLE TUBE

RÉGULATION DE LA TEMPÉRATURE D'UN TUBE D'ÉCHANTILLON DE RMN

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **18.10.2019 DE 102019216108**

(43) Veröffentlichungstag der Anmeldung:
**22.09.2021 Patentblatt 2021/38**

(73) Patentinhaber: **Bruker Switzerland AG**
**8117 Fällanden (CH)**

(72) Erfinder: **SCHMIDIG, Daniel**
**8200 Schaffhausen (CH)**

(74) Vertreter: **Kohler Schmid Möbus Patentanwälte**
**Partnerschaftsgesellschaft mbB**
**Gropiusplatz 10**
**70563 Stuttgart (DE)**

(56) Entgegenhaltungen:
**EP-A1- 2 388 609     EP-A2- 0 461 493**
**JP-A- S55 131 758     US-A1- 2007 007 963**

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

## Beschreibung

Die Erfindung betrifft das Temperieren eines NMR-Probenröhrchens, insbesondere eine Temperiereinrichtung, bei der um einen von einer zylindrischen Wand radial nach außen begrenzten Innenraum zur Aufnahme des NMR-Probenröhrchens mehrere ineinander angeordnete, radial um den Innenraum herum verlaufende Strömungskanäle für temperierendes Fluid ausgebildet sind, von denen der radial äußerste Strömungskanal durch eine axiale Wand und der radial innerste Strömungskanal durch eine axiale Wand jeweils in radialer Richtung nach außen begrenzt sind, wobei benachbarte Strömungskanäle jeweils mit einem ersten Fluiddurchlass an einem axialen Ende miteinander verbunden sind, wobei der radial innerste Strömungskanal einen zweiten Fluiddurchlass zum Innenraum aufweist, wobei der radial äußerste Strömungskanal an einem axialen Ende einen Fluideinlass aufweist, und wobei das temperierende Fluid durch die Strömungskanäle geführt wird.

Eine derartige Temperiereinrichtung sowie ein Verfahren zu deren Betrieb ist bekannt geworden aus der DE 10 2010 029 080 B4 beziehungsweise aus der US 8,847,595 B2 (= Referenz [1]).

### Hintergrund der Erfindung

Die vorliegende Erfindung befasst sich allgemein mit der Temperierung von NMR-Probenröhrchen, insbesondere mit einer verbesserten Fluid-Temperierung in einer Gegenstrom-Anordnung.

Die Kernspinresonanz (=NMR) ermöglicht grundlegende und leistungsfähige Verfahren der instrumentellen Analytik. Bei der NMR-Spektroskopie werden in eine Messprobe, die in einem starken, statischen Magnetfeld angeordnet ist, Hochfrequenz(=HF)-Pulse eingestrahlt, und die HF-Reaktion der Messprobe vermessen. Dabei werden die Informationen integral über einen gewissen Bereich der Messprobe, das aktive Volumen, gewonnen. Die Temperatur der Messprobe beeinflusst grundsätzlich die Ergebnisse der NMR-Messungen. Für hochwertige Messungen wird die Temperatur der Probe typischerweise mit Hilfe einer Temperiereinheit eingestellt und möglichst räumlich und zeitlich konstant über das aktive Messvolumen gehalten. NMR-Messungen werden also typischerweise wahlweise mit beheizten oder mit gekühlten Proben durchgeführt. Der räumliche Temperatur-Gradient über das aktive Messvolumen und die zeitliche Stabilität der Probentemperatur haben einen wesentlichen Einfluss auf die Qualität der NMR-Messungen.

Die Messprobe, also die Substanz, aus der analytische Informationen gewonnen werden sollen, ist bei den meisten verbreiteten NMR-Messverfahren in einem so genannten NMR-Probenröhrchen angeordnet. Typische NMR-Probenröhrchen haben einen Außendurchmesser von 5mm und eine Länge von ca. 18cm, wobei das aktive Volumen sich über ca. 25mm der Länge erstreckt. Im NMR-Spektrometer wird das NMR-Probenröhrchen an einem (meist dem oberen) Ende gehalten und das andere, freie (meist das untere) Ende ist von HF-Spulen umgeben, die oftmals in die Temperiereinrichtung integriert sind, und ragt in die Temperiereinrichtung hinein.

### Direktanströmung

Bei üblichen Temperiereinrichtungen umspült ein temperiertes Fluid -meist ein Gas wie Luft oder Stickstoff, in manchen Fällen aber auch eine Flüssigkeit- das Probenröhrchen mit der Messprobe zumindest im Bereich des aktiven Volumens, wie etwa in der DE 10 2012 217 601 B4 beziehungsweise der US 9,482,729 B2 (=Referenz [2]) beschrieben. Dort wird vor allem eine elektronische Regelung der Proben-Temperierung vorgeschlagen.

Im einfachsten Fall bildet die Temperiereinrichtung eine Kammer aus, in welche das Probenröhrchen mit dem freien Ende durch eine Öffnung hineinragt. Ein Fluidstrom wird dann in die Kammer eingeleitet, auf das freie Ende des Probenröhrchens gerichtet und innerhalb der Kammer in axialer Richtung am Probenröhrchen entlanggeführt. Solche einfachen Temperiereinrichtungen weisen jedoch relativ hohe Temperaturgradienten im Fluidstrom bzw. über die Länge des aktiven Volumens des NMR-Probenröhrchens auf, da der Fluidstrom während des Passierens der Kammer seine Temperatur der Umgebung annähert (also beispielsweise abkühlt im Falle eines heizenden Temperier-Fluidstroms). Ein Wärmefluss findet insbesondere über die Außenwand der Temperiereinrichtung, in der das Fluid strömt, und auch über das NMR-Probenröhrchen selbst in Richtung einer Röhrchenhalterung (Fixation) statt.

Das Prinzip der Direktanströmung wird heute vor allem im Bereich von kryogen gekühlten Proben eingesetzt, bei welchen designbedingt eine ausgezeichnete thermische Isolation vom Probenraum zur umliegenden Umgebung vorliegen muss. Dadurch ist der Wärmeverlust der Luft, welche die Probe umströmt, relativ klein, was wiederum in einem kleinen Temperaturgradienten über der Probe resultiert. Sobald diese thermische Isolation jedoch wegfällt oder wesentlich gemindert ist, wird das Prinzip der Direktanströmung unbrauchbar. Der Wärmeverlust der Luft, welche die Probe umströmt, wird zu groß. Damit wird auch der Temperaturgradient über der Probe zu groß.

### Gegenstromprinzip

Um den Temperaturgradienten im Fluidstrom, der das NMR-Probenröhrchen umgibt, zu verringern, ist es bekannt, Temperiereinrichtungen nach dem Gegenstromprinzip auszubilden, wie bereits in der DE 40 18 734 C2 beziehungsweise in der US 5,192,910 A (= Referenz [3]) beschrieben und dort etwa in der Figur 2 gezeigt ist.

Dabei wird ein Fluidstrom zunächst in einem äußeren, ringförmigen Strömungskanal in einer ersten axialen Richtung parallel zum Probenröhrchen geführt, danach umgelenkt und in der entgegengesetzten axialen Richtung in einem inneren Strömungskanal zurückgeführt, dann erneut umgelenkt und direkt am Probenröhrchen entlang und zu der Öffnung hinausgeführt, durch die das NMR-Probenröhrchen in den Innenraum der Temperiereinrichtungen ragt. Die Wände zwischen den Strömungskanälen und zum Innenraum fungieren als Wärmetauscher, so dass der Temperaturgradient im Fluidstrom direkt am Probenröhrchen verringert wird.

Wenn die Differenz zwischen der Umgebungstemperatur und der Probenraumtemperatur in der Temperiereinrichtung groß wird, kann mit einer Fluidführung im Gegenstromprinzip zwar eine Verkleinerung des Temperaturgradienten über der Probe erreicht werden. Durch das Gegenstromprinzip, wie es in Referenz [3] beschrieben ist, kann der Temperaturgradient jedoch keinesfalls minimiert oder im besten Fall gar gänzlich zum Verschwinden gebracht werden.

Obgleich das Gegenstromprinzip also grundsätzlich als eine Verbesserung des Prinzips der Direktanströmung anzusehen ist, bringt es immer noch einige Nachteile mit sich.

Für den Fall, dass die Umgebung der Temperiereinrichtung kälter ist als das Temperier-Fluid, ist es zudem so, dass die Probe im unteren Bereich durch das Temperier-Fluid wärmer wird als in ihrem oberen Bereich, da dieser in näheren thermischen Kontakt mit der Umgebung steht. Ist die Umgebung kälter als der Probenraum, so wird die Probe durch die Temperierung unten wärmer als oben. Der axiale Temperaturgradient ist in beiden Fällen entsprechend entgegengesetzt.

Beide Situationen haben den erheblichen Nachteil, dass eine Konvektion in der Probe begünstigt wird, was in der Regel lokal zu undefinierten Temperaturverhältnissen innerhalb des Probenröhrchens führt und damit zu einer Störung eines NMR Messsignals.

**Verbessertes Gegenstromprinzip**

Das Gegenstromprinzip wird bei NMR-Proben der Anmelderin seit 2001 erfolgreich eingesetzt, ab 2010 in einer verbesserten Version, wie sie in der eingangs zitierten Referenz [1] näher beschrieben ist. Dieses verbesserte Prinzip arbeitet mit einem zusätzlichen Mantelstrom und liefert immerhin einen geringeren Temperaturgradienten im Probenröhrchen, wobei gleichzeitig eine hohe Temperierleistung eingerichtet werden kann. Es funktioniert daher auch ohne die in Referenz [2] beschriebene, apparativ aufwändigere elektronische Temperaturregelung zufriedenstellend und findet seither Anwendung in vielen NMR-Spektrometern.

Ein wesentlicher Nachteil des Gegenstromprinzips, wie es etwa in den Referenzen [1] oder [3] beschrieben ist, besteht jedoch darin, dass der Temperaturgradient im NMR-Probenröhrchen prinzipiell nicht umgekehrt werden kann.

Sobald die -mittlere- Probentemperatur über die Umgebungstemperatur angehoben werden soll, kühlt das Temperier-Fluid, welches durch den Fluideinlass in ein axiales Ende des radial äußersten Strömungskanals einströmt, auf ihrem Weg durch diesen Strömungskanal (in der Regel nach oben) ab, sodass sie, wenn sie beim anderen axialen Ende des radial äußersten Strömungskanals im Bereich des ersten Fluiddurchlasses angelangt ist, schon wesentlich kälter ist als im Bereich des Fluideinlasses. Beim Weiterströmen des Temperier-Fluids durch den Innenraum bildet sich dadurch ein Temperaturgradient über der Probe aus (im vorliegenden Fall oben kalt, unten warm). Im umgekehrten Fall einer beabsichtigten Proben-Kühlung mittels eines Temperier-Fluids, welches beim Eintritt in den Fluideinlass eine geringere Temperatur als die Umgebung aufweist, heizt sich das Fluid auf der Strecke bis zum Bereich des zweiten Fluiddurchlasses entsprechend ab und es bildet sich wiederum ein -gegenüber dem vorher diskutierten Fall allerdings umgekehrteraxialer Temperaturgradient im Probenröhrchen aus.

Aufgabe der Erfindung

Der vorliegenden Erfindung liegt demgegenüber die Aufgabe zugrunde, ein Temperiersystem sowie ein Verfahren der eingangs beschriebenen Art mit möglichst einfachen technischen Mitteln dahingehend zu verbessern, dass die oben diskutierten Nachteile bekannter gattungsgemäßer Anordnungen vermieden werden. Insbesondere soll das mit der vorliegenden Erfindung verbesserte Temperierverfahren eine erhöhte Temperaturstabilität im Vergleich zu den Geräten nach dem Stand der Technik ermöglichen und die Möglichkeit bieten, den axialen Temperaturgradienten im Probenröhrchen weiter zu minimieren und stabil zu halten, vorzugsweise in der Nähe von Null.

Kurze Beschreibung der Erfindung

Diese -im Detail betrachtet relativ anspruchsvolle und komplexe- Aufgabe wird durch die vorliegende Erfindung auf ebenso überraschend einfache wie wirkungsvolle Weise dadurch gelöst, dass eine Temperiereinrichtung für ein NMR-Probenröhrchen bereitgestellt wird, wie sie im Anspruch 1 definiert wird. Im Betrieb wird die den Innenraum radial nach außen begrenzende zylindrische Wand der Temperiereinrichtung durch das temperierende Fluid derart temperiert, dass für die Temperatur Tw der zylindrischen Wand und die Temperatur $T_{FD}$ des temperierenden Fluids am ersten Fluiddurchlass in Relation zur Umgebungstemperatur Tu radial außerhalb der den radial äußersten Strömungskanal in radialer Richtung nach außen begrenzenden axialen Wand folgende Relation der absoluten Differenzwerte gilt:

$$abs(T_U - T_W) \leq abs(T_U - T_{FD}).$$

Bei der vorliegenden Erfindung geht es vor allem darum, eine möglichst «feinfühlige» Temperaturregelung des NMR-Probenröhrchens mit einem möglichst kleinen Temperaturgradienten im aktiven Volumen zu erreichen. Insbesondere ist es von Vorteil, wenn mit der erfindungsgemäßen Lehre eine Umkehrung des Temperaturgradienten des Fluidstroms außen an der Probe entlang gegenüber dem Temperaturgradienten in der Probe erreicht wird. Durch Einstellung von $T_{FD}$ gegenüber Tu und Tw ist damit eine gleichmäßige Regelung der Probentemperatur möglich.

Dieses Ziel wird erfindungsgemäß insbesondere erreicht durch die spezielle Temperierung der den Innenraum mit dem NMR-Probenröhrchen radial nach außen begrenzenden zylindrischen Wand. Diese spezielle Temperierung kann auf verschiedene Weise und mit unterschiedlichen Maßnahmen erreicht werden, wie weiter unten näher erläutert wird.

Im Vergleich zu Gegenstrom-Temperiersystemen nach dem Stand der Technik, bei welchen der oben beschriebene Effekt einer Abkühlung eines heizenden Temperierfluids beziehungsweise einer Aufheizung eines kühlenden Temperierfluids prinzipiell immer auftreten muss, wodurch dann notwendigerweise ein entsprechender axialer Temperaturgradient längs der den Innenraum radial nach außen begrenzende zylindrische Wand durch das temperierende Fluid aufgebaut wird, den diese Wand wiederum zumindest teilweise auf das NMR-Probenröhrchen überträgt, wird dieser Effekt durch die vorliegende Erfindung minimiert, so dass im günstigsten Fall überhaupt kein solcher axialer Temperaturgradient in der NMR-Probe mehr auftritt.

Bevorzugte Ausführungsformen und Weiterbildungen der Erfindung

Wie oben bereits ausgeführt, wird erfindungsgemäß eine Temperiereinrichtung für ein NMR-Probenröhrchen bereitgestellt, wie sie in Anspruch 1 definiert wird. Es handelt sich hierbei um eine Temperiereinrichtung, wobei um einen von einer zylindrischen Wand radial nach außen begrenzten Innenraum zur Aufnahme des NMR-Probenröhrchens mehrere ineinander angeordnete, radial um den Innenraum herum verlaufende Strömungskanäle für temperierendes Fluid ausgebildet sind, von denen der radial äußerste Strömungskanal, welcher durch axiale Wände begrenzt ist, eine äußere Abteilung und eine innere Abteilung umfasst, die so ausgebildet sind, dass das temperierende Fluid in der äußeren und inneren Abteilung im Betrieb in der gleichen Richtung strömt, wobei die Temperiereinrichtung in einem ersten axialen Endbereich geschlossen zum Innenraum und in einem gegenüberliegenden zweiten axialen Endbereich für das Einführen des NMR-Probenröhrchens in den Innenraum offen zum Innenraum ausgebildet ist, wobei in einem Gegenstrombereich benachbarte Strömungskanäle jeweils mit einem ersten Fluiddurchlass an einem axialen Ende so miteinander verbunden sind, dass sich die Strömungsrichtung eines Fluidstroms im radial äußersten Strömungskanal zum benachbarten radial innersten Strömungskanal im Gegenstrombereich umkehrt, wobei der radial äußerste Strömungskanal an einem axialen Ende einen Fluideinlass aufweist, und wobei der radial innerste Strömungskanal, welcher durch die axialen Wände begrenzt ist, an einem axialen Ende, das dem geschlossen ausgebildeten ersten axialen Endbereich zugewandt ist, einen zweiten Fluiddurchlass zum Innenraum aufweist.

Die Temperiereinrichtung zeichnet sich erfindungsgemäß dadurch aus, dass die äußere Abteilung des radial äußersten Strömungskanals geometrisch so gestaltet ist, dass sie in flächigem thermischen Kontakt sowohl mit der radial inneren axialen Wand als auch mit der radial äußeren axialen Wand steht, dass die äußere Abteilung die innere Abteilung des radial äußersten Strömungskanals derart umgibt, dass die innere Abteilung weder in thermischem Kontakt mit der radial inneren axialen Wand noch mit der radial äußeren axialen Wand steht, und dass die innere Abteilung des radial äußersten Strömungskanals von einer axialen Zwischenwand begrenzt ist, welche sich ausgehend von dem geschlossen ausgebildeten ersten axialen Endbereich nur so weit in axialer Richtung erstreckt, dass sie vom zweiten axialen Endbereich axial beabstandet ist. Dies ist deshalb besonders vorteilhaft, weil durch die beschriebene Aufteilung der Fluidströme eine Umkehrung bzw. Minimierung des Temperaturgradienten im Probenbereich erreicht werden kann.

Ganz besonders bevorzugt sind Ausführungsformen dieser Klasse von Temperiereinrichtungen, bei welchen die äußere Abteilung des radial äußersten Strömungskanals so ausgebildet ist, dass die Strömungsgeschwindigkeit des temperierenden Fluids durch die äußere Abteilung kleiner ist als durch die innere Abteilung, vorzugsweise höchstens halb so groß, insbesondere mindestens zehnmal geringer, besonders bevorzugt, dass die Strömungsgeschwindigkeit des temperierenden Fluids durch die äußere Abteilung gegen Null geht. Die Tatsache, dass der Temperaturgradient in der Probe über die Strömungsgeschwindigkeiten in den entsprechenden Abteilungen eingestellt werden kann, ermöglicht es, die Temperiereinrichtung so zu gestalten, dass der Temperaturgradient bei einer vorgegebenen Probentemperatur minimal ist.

Vorteilhaft sind auch Ausführungsformen dieser Klasse von Temperiereinrichtungen, bei denen die äußere Abteilung des radial äußersten Strömungskanals einen größeren Strömungsquerschnitt quer zur Strömungsrichtung des temperierenden Fluids aufweist als die innere Abteilung, vorzugsweise einen mindestens doppelt so großen Strömungsquerschnitt, insbesondere mindestens den zehnfachen Strömungsquerschnitt. Indem man die Querschnitte der Strömungskanäle so wählt, dass die resultierenden Strömungsgeschwindigkeiten entsprechend kleiner oder größer werden, kann man die Temperiereinrichtung so gestalten, dass der Temperaturgradient bei einer vorgegebenen Probentemperatur minimal wird.

Weitere vorteilhafte Ausführungsformen zeichnen sich dadurch aus, dass die die äußere Abteilung und die innere Abteilung des radial äußersten Strömungskanals so ausgestaltet sind, dass die mittlere Durchflussmenge an temperierendem Fluid durch die äußere Abteilung des radial äußersten Strömungskanals kleiner ist als durch die innere Abteilung, vorzugsweise höchstens halb so groß ist, insbesondere mindestens zehnmal geringer ist, besonders bevorzugt gegen Null geht. Dies ist deshalb besonders vorteilhaft, weil durch die beschriebene Aufteilung der Fluidströme eine Umkehrung bzw. Minimierung des Temperaturgradienten im Probenbereich erreicht werden kann.

Die innere Abteilung des radial äußersten Strömungskanals sowie auch die äußere Abteilung können sich in axialer Richtung über die gesamte Länge des radial äußersten Strömungskanals bis zum ersten Fluiddurchlass erstrecken.

Vorteilhaft sind auch Ausführungsformen der erfindungsgemäßen Temperiereinrichtung, die dadurch gekennzeichnet sind, dass der Strömungskontakt zwischen der inneren Abteilung und der äußeren Abteilung des radial äußersten Strömungskanals variabel eingestellt werden kann.

Vorzugsweise weist die axiale Zwischenwand, welche die innere Abteilung des radial äußersten Strömungskanals begrenzt, Ausnehmungen auf, insbesondere in Form von variabel verschließbaren Löchern, durch die ein Strömungskontakt zwischen der inneren Abteilung und der äußeren Abteilung hergestellt werden kann. Damit kann die effektive axiale Länge der inneren Abteilung quasi virtuell variiert werden. Diese virtuelle Variation der effektiven axialen Länge der inneren Abteilung erlaubt es, den Temperaturgardienten im Probenbereich besonders feinfühlig einzustellen. Insbesondere ist es denkbar, bei der Produktion der Temperiereinrichtung die Anzahl der verschlossenen Löcher so zu wählen, dass der Temperaturgradient im Probenbereich minimal wird. Dies ist eine überraschend einfache und effektive Methode, den Temperaturgradienten im Probenbereich bereits bei der Produktion der Temperiereinrichtung einzustellen.

Ein weiterer Vorteil dieser Ausführung liegt darin, dass ein Mechanismus ermöglicht wird, der es erlaubt, die Anzahl der verschlossenen Löcher von außen zu verstellen. So wird dem Benutzer die Möglichkeit eröffnet, den Temperaturgradienten im Probenbereich während des Betriebes der Temperiereinrichtung ein- und umzustellen.

Alternativ oder ergänzend kann bei anderen Ausführungsformen dieser Klasse von Temperiereinrichtungen die axiale Zwischenwand, welche die innere Abteilung des radial äußersten Strömungskanals begrenzt, so ausgestaltet sein, dass sie eine thermische Isolation gegenüber der äußeren Abteilung bewirkt und einen Wärmedurchgangskoeffizienten von weniger als 4

$W/(m^2K)$ aufweist, was sich in der Praxis bewährt.

Besonders bevorzugt ist eine Ausführungsform, bei der die innere Abteilung des radial äußersten Strömungskanals als Kapillare mit geschlossener Zwischenwand, als Kapillar-Segment oder als vollständig radial umlaufender Kapillar-Kanal ausgebildet ist. Dabei bietet die Ausbildung der Strömungskanäle als Kapillare vor allem eine einfache technische Realisierbarkeit unter Beibehaltung aller anderer beschriebenen Vorteile. Eine entsprechende Ausführungsform ist auch deshalb besonders vorteilhaft, weil dadurch eine Umkehrung bzw. Minimierung des Temperaturgradienten im Probenbereich erreicht werden kann.

Von besonderem Vorteil sind auch Ausführungsformen, die dadurch gekennzeichnet sind, dass der Fluideinlass in mindestens zwei separate Einlässe aufgespalten ist, wobei der erste Einlass in die äußere Abteilung des radial äußersten Strömungskanals, der zweite Einlass in die innere Abteilung mündet und dass vorzugsweise die Durchflussmenge pro Zeiteinheit oder die Temperatur von temperierendem Fluid des durch den ersten Einlass in die äußere Abteilung strömenden Fluids separat zu dem durch den zweiten Einlass in die innere Abteilung strömenden Fluid geregelt werden kann. Dies ist deshalb besonders vorteilhaft, weil mittels einer Regelung der Fluidmengen durch die entsprechenden Einlässe der Temperaturgradient in der NMR-Probe geregelt werden kann.

Bei bevorzugten Weiterbildungen dieser Ausführungsformen ist eine Ventileinrichtung zur Regelung der Fluidströme durch den ersten Einlass und durch den zweiten Einlass vorhanden. Diese Weiterbildungen sind deshalb besonders vorteilhaft, weil durch eine Regelung der Fluidmengen durch die entsprechenden Einlässe der Temperaturgradient in der NMR-Probe geregelt werden kann. Die Ventileinrichtung kann sich sowohl innerhalb als auch außerhalb des NMR-Sensors befinden, was eine Implementation wesentlich vereinfacht. Die Regelung kann geschehen ohne, dass die Temperiereinrichtung geöffnet wird. Dies ermöglicht es den Temperaturgradienten im Betrieb der Temperiereinrichtung , insbesondere während dieser auf sehr hohe oder sehr tiefe Temperaturen temperiert ist, einzustellen. Durch das beschriebene Verfahren und die beschriebene Ventileinrichtung ist es auch möglich, bewusst einen Temperaturgradienten in der Probe zu erzeugen. Das könnte zum Beispiel dann der Fall sein, wenn man sichergehen will, dass keine Konvektion im Probenvolumen auftritt, und man deshalb bewusst einen Temperaturgradienten im vorbeiströmenden Temperierfluid erzeugt, der im unteren Bereich der Probe etwas höher ist.

In der Praxis wird der Gegenstrombereich der erfindungsgemäßen Temperiereinrichtung genau zwei ineinander geschachtelte Strömungskanäle umfassen, von denen der radial äußere eine äußere Abteilung und eine innere Abteilung aufweist.

Der erste axiale Endbereich der Temperiereinrichtung weist zumeist ein unteres Abschlussstück auf, durch welches der Fluideinlass führt. Der zweite axiale Endbereich am gegenüberliegenden Ende der Temperiereinrichtung wiederum weist ein entsprechendes oberes Abschlussstück auf, welches als geschlossener Deckel ausgebildet sein kann, aber auch einen Fluidauslass aufweisen kann, durch welchen ein Teilstrom des temperierenden Fluids, das vom Fluideinlass her durch den radial äußersten Strömungskanal geflossen ist, nach außerhalb der Temperiereinrichtung entweichen kann. Der Fluideinlass und/oder ein Fluidauslass im Abschlussstück des zweiten axialen Endbereichs und/oder mindestens einer der beiden Fluiddurchlässe können durch einen ringförmigen Spalt und/oder durch mehrere, symmetrisch um eine Mittelachse des Innenraums verteilte Öffnungen ausgebildet sein.

Die erfindungsgemäße Temperiereinrichtung ist normalerweise Bestandteil eines NMR-Probenkopfes. Dieser umfasst, wie allgemein üblich, eine Messprobenkammer, die im Betrieb eine Messprobe aufnimmt und optional aus einem Material mit geringer thermischer Leitfähigkeit bestehen kann. Diese Messprobenkammer ist Bestandteil der hier beschriebenen erfindungsgemäßen Temperiereinrichtung. Der Probenkopf enthält weiterhin eine erste Sende-/Empfangsspule, welche die Messproben-kammer umgibt oder von dieser umgeben wird. Vorzugsweise umfasst der Messkopf auch ein Netzwerk zum Abstimmen verschiedener Resonanz-frequenzen auf der ersten Sende-/Empfangsspule. Weiterhin umfasst der Probenkopf optional eine zweite Sende-/Empfangsspule, auf der weitere Messkerne abgestimmt sein können, z.B. die Lockfrequenz. In einer anderen Ausführungsform enthält der Messkopf eine weitere Messprobe mit einer Substanz, die durch eine zweite oder dritte Sende-/Empfangsspule detektiert wird und als Referenzsignal für den Lock verwendet wird.

Weitere Vorteile der Erfindung ergeben sich aus der Beschreibung und der Zeichnung. Ebenso können die vorstehend genannten und die noch weiter ausgeführten Merkmale erfindungsgemäß jeweils einzeln für sich oder zu mehreren in beliebigen Kombinationen Verwendung finden, sofern dadurch der Schutzbereich der durch die Ansprüche definierten Erfindung nicht verlassen wird.

Die gezeigten und beschriebenen Ausführungsformen sind nicht als abschließende Aufzählung zu verstehen, sondern haben vielmehr beispielhaften Charakter für die Schilderung der Erfindung.

Detaillierte Beschreibung der Erfindung und Zeichnung

Die Erfindung ist in der Zeichnung dargestellt und wird anhand von Ausführungsbeispielen näher erläutert.

Es zeigen:

Fig. 1 eine schematische Vertikalschnittansicht einer ersten Ausführungsform des erfindungsgemäßen Temperiersystems mit Temperierung der den radial innersten Strömungskanal in radialer Richtung nach außen begrenzenden axialen Wand, wobei der radial äußerste Strömungskanal eine äußere und eine innere Abteilung umfasst;

Fig. 2 eine Ausführungsform wie in Fig. 1, aber mit einem Fluidauslass im oberen Abschlussstück des zweiten axialen Endbereichs;

Fig. 3 eine Ausführungsform wie in Fig. 1 oder 2, aber mit einer Ventileinrichtung zur Regelung der Fluidströme durch den ersten Einlass in die äußere Abteilung und durch den zweiten Einlass in die innere Abteilung;

Fig. 4a eine schematische Horizontalschnittansicht senkrecht zur z-Achse durch eine Ausführungsform mit einer inneren Abteilung des radial äußersten Strömungskanals, die aus mehreren azimutal um die z-Achse angeordneten Kapillaren aufgebaut ist;

Fig. 4b eine schematische Horizontalschnittansicht durch eine Ausführungsform mit als ringförmiger, um die z-Achse herumlaufender Kapillare ausgebildeten inneren Abteilung;

Fig. 4c eine schematische Horizontalschnittansicht durch eine Ausführungsform mit als ringförmiger, um die z-Achse herumlaufender Kapillare ausgebildeten inneren Abteilung, die in vier azimutale, voneinander getrennte Segmente aufgeteilt ist;

Fig. 5a ein errechnetes axiales Temperaturprofil im NMR-Probenröhrchen eines Temperiersystems nach dem Stand der Technik längs der z-Achse; und

Fig. 5b ein errechnetes axiales Temperaturprofil im NMR-Probenröhrchen eines hinsichtlich seiner Abmessungen mit Fig. 5a vergleichbaren, jedoch erfindungsgemäßen Temperiersystems.

Die vorliegende Erfindung betrifft die Temperierung von NMR-Probenröhrchen mit erhöhter Temperaturstabilität und minimiertem axialen Temperaturgradienten im Probenröhrchen.

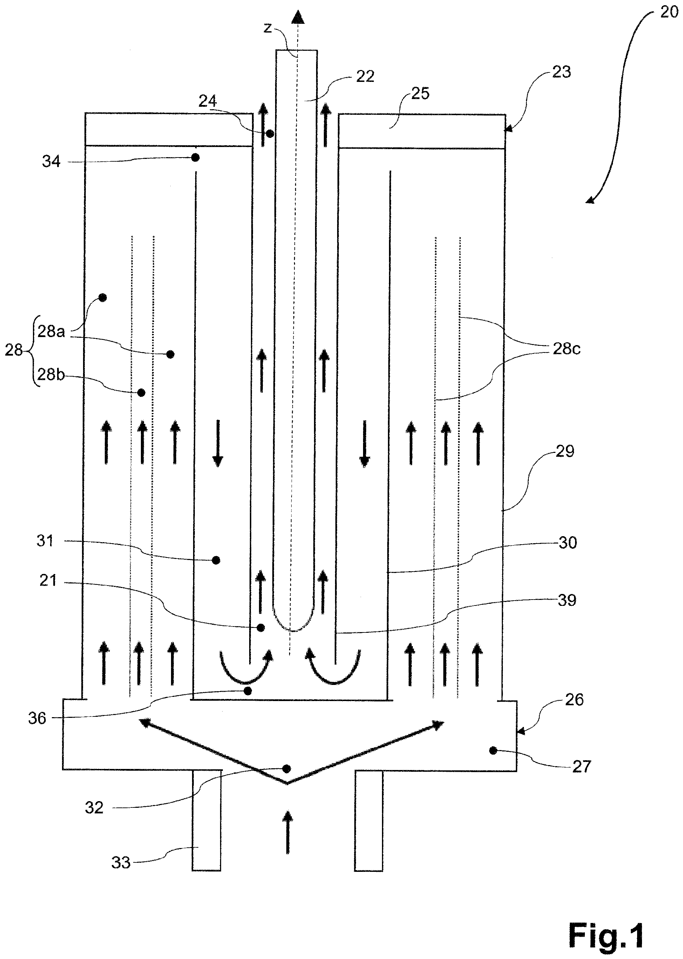

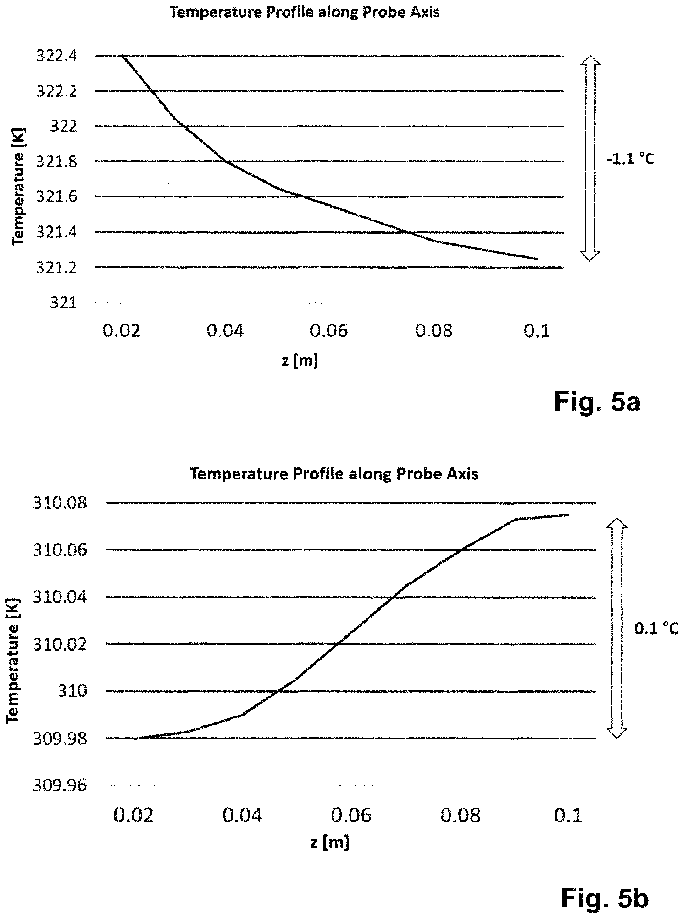

Die Figuren 1 bis 4c der Zeichnung stellen jeweils in einer schematischen Ansicht in unterschiedlichem Detail bevorzugte Ausführungsformen des erfindungsgemäßen Temperiersystems dar, während Fig. 5b den axialen Temperaturgradienten im Probenröhrchen einer erfindungsgemäßen Anordnung und Fig. 5a zum Vergleich bei einer generischen Anordnung nach dem Stand der Technik darstellen.

NMR-Proberöhrchen werden üblicherweise bei einer definierten Temperatur betrieben, insbesondere vermessen. Diese Temperatur wird über das NMR-Spektrometer eingestellt und soll so stabil wie möglich gehalten werden. Das Konstanthalten der Temperatur ist notwendig, weil die in NMR-Technik erzeugten Spektren eine erhebliche Abhängigkeit von der Temperatur der zu untersuchenden Substanz im Proberöhrchen aufweisen, welche dazu führt, dass Änderungen in der Umgebungstemperatur schlussendlich in das Messresultat eingehen, was zur Verschiebung einzelner gemessener Frequenzlinien führen kann. Je nach Experiment sind diese Effekte mehr oder weniger störend und verfälschen die Messung. Um möglichst aus allen Teilen des aktiven Volumens im NMR-Proberöhrchen gleichartige Beiträge zum magnetischen Wechselfeld zu erhalten, ist daher eine möglichst gleichmäßige Temperatur im gesamten aktiven Volumen erforderlich, d.h. der Temperaturgradient im NMR-Proberöhrchen, insbesondere in axialer Richtung, sollte gering sein und möglichst gegen Null gehen.

Die **Figuren 1 bis 3** zeigen jeweils eine Ausführungsform einer erfindungsgemäßen **Temperiereinrichtung 20** zur Temperierung eines **NMR-Probenröhrchens 22** mit einer **Längsachse z,** wobei um einen von einer **zylindrischen Wand 39** radial nach außen begrenzten **Innenraum 21** zur Aufnahme des NMR-Probenröhrchens 22 mehrere ineinander angeordnete, radial um den Innenraum 21 herum verlaufende Strömungskanäle für temperierendes Fluid ausgebildet sind, von denen der **radial äußerste Strömungskanal 28** durch eine **radial äußere axiale Wand 29** und der **radial innerste Strömungskanal 31** durch eine **radial innere axiale Wand 30** jeweils in radialer Richtung nach außen begrenzt sind. In einem Gegenstrombereich sind benachbarte Strömungskanäle 28, 31 jeweils mit einem **ersten Fluiddurchlass 34** an einem axialen Ende so miteinander verbunden, dass sich die Strömungsrichtung eines Fluidstroms im radial äußersten Strömungskanal 28 zum benachbarten radial innersten Strömungskanal 31 im Gegenstrombereich umkehrt. Der radial innerste Strömungskanal 31 weist einen **zweiten Fluiddurchlass 36** zum Innenraum 21 auf, wobei der radial äußerste Strömungskanal 28 an einem axialen Ende einen **Fluideinlass 32** aufweist, in welchen das temperierende Fluid aus einem **gemeinsamen Zulauf 33** einströmt, und wobei das temperierende Fluid durch die Strömungskanäle 28, 31 geführt wird.

Der radial äußerste Strömungskanal 28, welcher durch axiale Wände 29, 30 begrenzt ist, umfasst erfindungsgemäß jeweils eine **äußere Abteilung 28a** und eine **innere Abteilung 28b,** in denen das temperierende Fluid in der gleichen Richtung strömt (Mantelstromprinzip). Die Temperiereinrichtung 20 ist in einem **ersten axialen Endbereich 26** geschlossen zum Innenraum 21 und in einem gegenüberliegenden **zweiten axialen Endbereich 23** für das Einführen des NMR-Probenröhrchens 22 in den Innenraum 21 offen zum Innenraum 21 ausgebildet. Der erste axiale Endbereich 26 weist ein **unteres Abschlussstück 27** auf, durch welches der Fluideinlass 32 führt. Der zweite axiale Endbereich 23 am gegenüberliegenden Ende der Temperiereinrichtung 20 wiederum weist ein entsprechendes **oberes Abschlussstück 25** auf, welches als geschlossener Deckel ausgebildet sein kann, wie in **Fig. 1** dargestellt. Das NMR-Probenröhrchen 22 ragt mit seinem freien Ende durch eine **Öffnung 24** im oberen Abschlussstück 25 in den Innenraum 21 hinein. Ein Fluidstrom wird dann in die Kammer eingeleitet, auf das freie Ende des Probenröhrchens gerichtet und innerhalb der Kammer in axialer Richtung am Probenröhrchen entlang und zu der Öffnung 24 hinausgeführt.

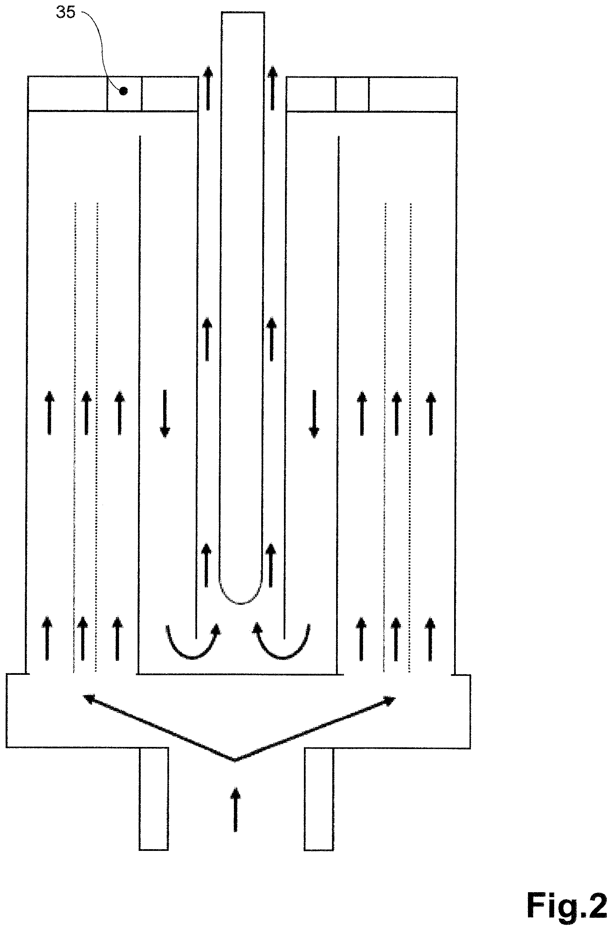

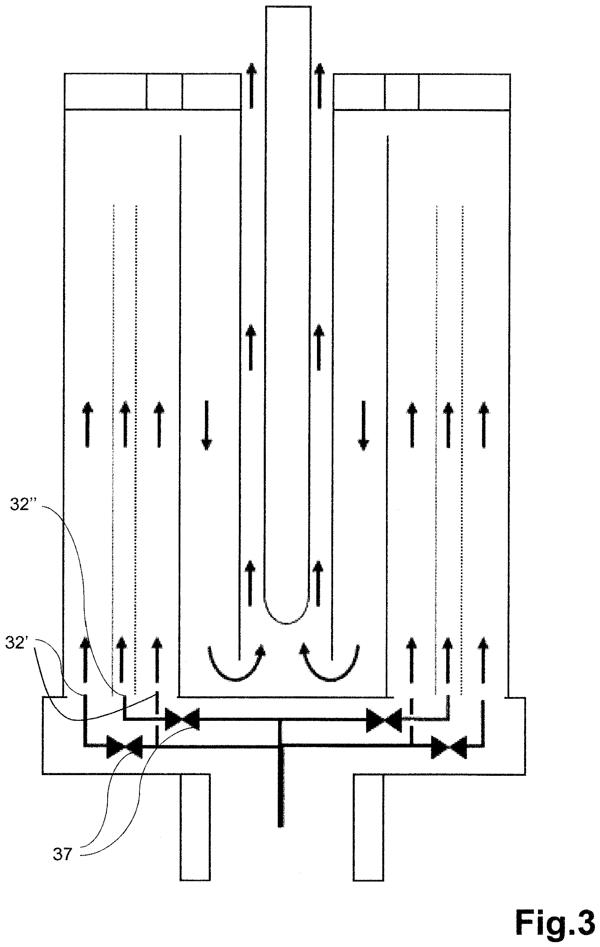

Bei anderen Ausführungsformen (siehe etwa die **Figuren 2 und 3)** kann das obere Abschlussstück 25 auch einen **Fluidauslass 35** aufweisen, durch welchen ein Teilstrom des temperierenden Fluids, das vom Fluideinlass 32 her durch den radial äußersten Strömungskanal 28 geflossen ist, nach außerhalb der Temperiereinrichtung 20 entweichen kann. Die genaue Wirkungsweise und zusätzlichen Vorteile eines solchen Fluidauslasses 35 im oberen Abschlussstück 25 sind in Referenz [1] detailliert beschrieben.

Der Fluideinlass 32 und/oder ein Fluidauslass 35 im oberen Abschlussstück 25 des zweiten axialen Endbereichs 23 und/oder mindestens einer der beiden Fluiddurchlässe 34,36 können durch einen ringförmigen Spalt und/oder durch mehrere, symmetrisch um eine Mittelachse des Innenraums verteilte Öffnungen ausgebildet sein.

Das erfindungsgemäße Temperiersystem zeichnet sich dadurch aus, dass im Betrieb die den Innenraum 21 radial nach außen begrenzende zylindrische Wand 39 durch das temperierende Fluid derart temperiert wird, dass für die Temperatur Tw der zylindrischen Wand 39 und die Temperatur $T_{FD}$ des temperierenden Fluids am ersten Fluiddurchlass 34 in Relation zur Umgebungstemperatur Tu radial außerhalb der den radial äußersten Strömungskanal 28 in radialer Richtung nach außen begrenzenden axialen Wand 29 folgende Relation der absoluten Differenzwerte gilt:

$$abs(T_U\text{-}T_W) \leq abs(T_U\text{-}T_{FD}),$$

vorzugsweise $2 \cdot abs(T_U\text{-}T_W) \leq abs(T_U\text{-}T_{FD})$, insbesondere $10 \cdot abs(T_U\text{-}T_W) \leq abs(T_U\text{-}T_{FD})$, besonders bevorzugt $100 \cdot abs(T_U\text{-}T_W) \leq abs(T_U\text{-}T_{FD})$.

Bei den in den **Figuren 1 bis 3** gezeigten Ausführungsformen der erfindungsgemäßen Temperiereinrichtung 20 wird die Temperierung der zylindrischen Wand 39 durch eine Temperierung der den radial innersten Strömungskanal 31 in radialer Richtung nach außen begrenzenden axialen Wand 30 bewirkt.

Im Betrieb wird hierbei in die innere Abteilung 28b des radial äußersten Strömungskanals 28 pro Zeiteinheit mehr temperierendes Fluid eingespeist, als in die äußere Abteilung 28a, vorzugsweise mindestens doppelt so viel, insbesondere mindestens zehnmal so viel, besonders bevorzugt mehr als das Hundertfache.

Ausführungsformen, wie sie in den Figuren 1 bis 3 dargestellt sind, verbessern die aus dem Stand der Technik bekannten Temperier-Anordnungen erheblich und erweitern sie um folgende erfindungswesentlichen Elemente:

Die äußere Abteilung 28a des radial äußersten Strömungskanals 28 ist bei diesen Ausführungsformen geometrisch so gestaltet, dass sie sowohl mit der radial inneren axialen Wand 30 als auch mit der radial äußeren axialen Wand 29 in flächigem thermischen Kontakt steht. Sie umgibt die innere Abteilung 28b derart, dass die innere Abteilung 28b weder in thermischem Kontakt mit der radial inneren axialen Wand 30 noch mit der radial äußeren axialen Wand 29 steht. Die innere Abteilung 28b ist von einer **axialen Zwischenwand 28c** begrenzt, welche sich -ausgehend von dem geschlossen ausgebildeten ersten axialen Endbereich 26- nur so weit in axialer Richtung erstreckt, dass sie vom zweiten axialen Endbereich 23 axial beabstandet ist.

Die erfinderische Idee besteht erfindungsgemäß nun darin, dass das Fluid, welches beim Fluideinlass 32 einströmt, nicht im radial äußersten Strömungskanal 28 verteilt und auf dem ganzen Strömungsumfang zum zweiten axialen Endbereich 23 (in der Regel nach oben) und dann zum ersten Fluiddurchlass 34 geleitet wird, sondern in der erfindungsgemäß vorgesehenen inneren Abteilung 28b -zumeist einer dünnen, im Optimalfall thermisch isolierten Kapillare, einem Kapillar-Segment oder einem vollständig umlaufenden Kapillar-Kanal- zum ersten Fluiddurchlass 34 strömt und erst dort verteilt wird. Das hat zur Folge, dass das Fluid -im Falle einer beabsichtigen Aufheizung der Probe- in der inneren Abteilung 28b auf dem Weg vom Fluideinlass 32 zum zweiten axialen Endbereich 23 nur unwesentlich abkühlt (höhere Fließgeschwindigkeit + bessere Isolation) und erst beim Strömen durch den ersten Fluiddurchlass 34 zum zweiten Fluiddurchlass 36 in den Innenraum 21 stärker abkühlt und die Probe dadurch unten kälter wird als oben. Indem man die Länge der Kapillare geeignet auswählt, kann der Temperaturgradient minimiert werden.

Für das temperierende Fluid, das am zweiten axialen Endbereich 23 aus der inneren Abteilung 28b austritt, sind zwei Fallgestaltungen möglich:

a) Hatte das Fluid beim Eintritt in den Fluideinlass 32 eine höhere Temperatur als die Umgebungstemperatur Tu (Heizen der Probe), so wird die Temperatur des Fluidstroms durch die äußere Abteilung 28a aufgrund des flächigen thermischen Kontakts mit der äußeren axialen Wand 29 in Strömungsrichtung abkühlen. Diese niedrigere Temperatur wird das Fluid durch horizontale Konvektion an die radial innere axiale Wand 30 weitergeben, mit der es ebenfalls in flächigem thermischen Kontakt steht. Dadurch wird der radial innere axiale Wand 30 vom Fluid in der äußeren Abteilung 28a eine Temperatur zwischen der niedrigeren Umgebungstemperatur Tu und der ursprünglich höheren Temperatur des Fluids beim Eintritt in den Fluideinlass 32 aufgeprägt.

Der von den Wänden 29 und 30 thermisch abgekoppelte Fluidstrom durch die innere Abteilung 28b hingegen wird auch bei seinem Austritt aus der inneren Abteilung 28b beim zweiten axialen Endbereich 23 immer noch im Wesentlichen dieselbe -höhere- Temperatur haben, wie bei seinem Eintritt in den Fluideinlass 32. Beim Übergang des Fluids durch den ersten Fluiddurchlass in den radial innersten Strömungskanal 31 wird daher der (nunmehr wieder vereinigte) Fluidstrom aus dem radial äußersten Strömungskanal 28 in Strömungsrichtung von-der-relativ kühleren- radial inneren axialen Wand 30 abgekühlt werden. In gleicher Weise wird dann durch Konvektion auch die zylindrische Wand 39 des Innenraums 21 von außen durch das vorbeiströmende Fluid wie die innere axiale Wand 30 temperiert.

Wenn nun der Fluidstrom durch die innere Abteilung 28b deutlich größer ist als derjenige durch die äußere Abteilung 28a, so wird also dem ansonsten entstehenden axialen Temperaturgradienten der zylindrischen Wand 39 des Innenraums 21 entgegengewirkt und damit eine besonders gleichmäßige Temperaturverteilung im gesamten aktiven Volumen des NMR-Probenröhrchens 22 bewirkt. Im günstigsten Fall kann der Gradient sogar auf Null gesenkt werden.

b) Hatte das Fluid beim Eintritt in den Fluideinlass 32 eine niedrigere Temperatur als die Umgebungstemperatur Tu (Kühlen der Probe), so ergibt sich -mit den gleichen Überlegungen wie oben unter a) ausgeführt, jedoch mit umgekehrten Temperaturdifferenzen relativ zu Tu- wiederum eine Erniedrigung des absoluten Werts des axialen Temperaturgradienten der zylindrischen Wand 39 des Innenraums 21 und damit ebenfalls eine besonders gleichmäßige Temperaturverteilung im gesamten aktiven Volumen des NMR-Probenröhrchens 22.

Der Fluideinlass 32 kann in mehrere separate Einlässe 32', 32" aufgespalten sein, wobei der **erste Einlass 32'** in die äußere Abteilung 28a des radial äußersten Strömungskanals 28, der **zweite Einlass 32"** in die innere Abteilung 28b mündet. Vorzugsweise wird die Durchflussmenge pro Zeiteinheit oder die Temperatur von temperierendem Fluid des durch den ersten Einlass 32' in die äußere Abteilung 28a strömenden Fluids separat zu dem durch den zweiten Einlass 32" in die innere Abteilung 28b strömenden Fluid geregelt.

Dazu kann eine eine **Ventileinrichtung 37** zur Regelung der Fluidströme durch den ersten Einlass 32' und durch den zweiten Einlass 32" vorgesehen sein, wie sie in **Fig. 3** dargestellt ist.

Indem man einstellt, wieviel Fluid am Fluideinlass 32 (in der Regel unten) über den Umfang der äußeren Abteilung 28a verteilt wird und wieviel Fluid in der inneren Abteilung 28b zum zweiten axialen Endbereich 23 (in der Regel nach oben) fließt, kann der Temperaturgradient über der Probe feinfühlig eingestellt und sogar völlig zum Verschwinden gebracht werden. Insbesondere in einem DIFF-BB-Probenkopf zur Erstellung eines Differential-Blutbilds in der Labormedizin ist diese Möglichkeit, den Temperaturgradienten zum Verschwinden zu bringen, von großem Interesse.

Die innere Abteilung 28b muss sich nicht zwingend über die gesamte axiale Ausdehnung des radial äußersten Strömungskanals 28 bis zum ersten Fluiddurchlass 34 erstrecken. Indem man die Länge der inneren Abteilung 28b variiert, kann der Temperaturgradient der Probe noch feinfühliger eingestellt werden. Insbesondere kann (bei in der Zeichnung nicht eigens dargestellten Ausführungsformen der Erfindung) der Strömungskontakt zwischen der inneren Abteilung 28b und der äußeren Abteilung 28a variabel eingestellt werden.

Vorzugsweise weist die axiale Zwischenwand 28c, welche die innere Abteilung 28b des radial äußersten Strömungskanals 28 begrenzt, Ausnehmungen auf, insbesondere in Form von variabel verschließbaren Löchern, durch die ein Strömungskontakt zwischen der inneren Abteilung 28b und der äußeren Abteilung 28a hergestellt werden kann. Damit kann die effektive axiale Länge der inneren Abteilung 28b quasi virtuell variiert werden.

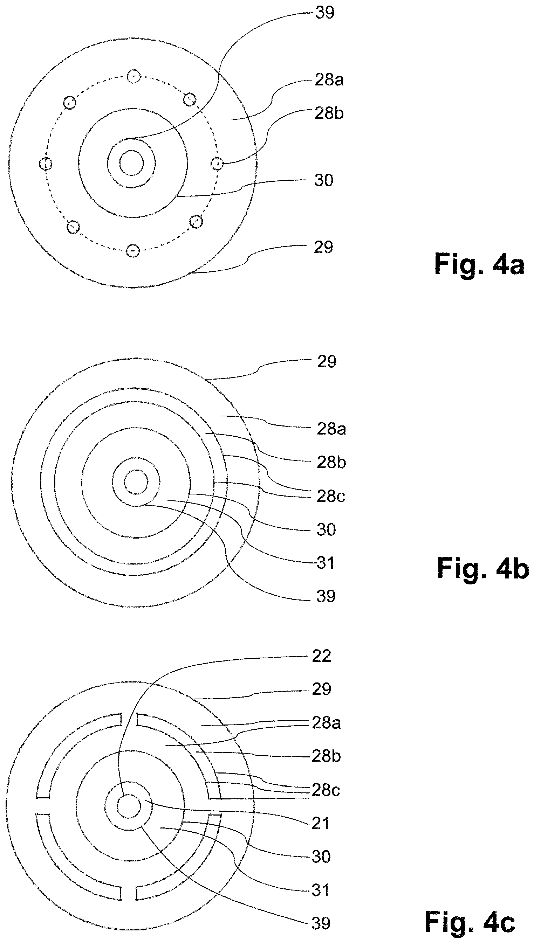

Die **Figuren 4a bis 4c** zeigen diverse geometrische Gestaltungsmöglichkeiten der inneren Abteilung 28b des radial äußersten Strömungskanals 28:
In **Fig. 4a** umfasst die innere Abteilung 28b eine Vielzahl von -vorzugsweise gleichmäßig verteilt- um die z-Achse angeordneten Einzel-Kapillaren.

Bei der Ausführungsform nach **Fig. 4b** ist die innere Abteilung 28b als vollständig radial umlaufender Kapillar-Kanal mit geschlossener axialer Zwischenwand 28c ausgebildet. Um einen Fluidaustausch zwischen dem Bereich außerhalb und innerhalb des Kapillar-Kanals zu ermöglichen, sind zur inneren Abteilung geschlossen ausführte Durchgangsöffnungen möglich - die allerdings in der Zeichnung nicht eigens dargestellt sind.

**Fig. 4c** stellt eine Variante dar, bei welcher die innere Abteilung 28b durch eine Vielzahl von um die z-Achse angeordneten, jeweils für sich geschlossenen Kapillar-Segmenten gebildet wird.

Bei -in der Zeichnung nicht dargestellten- Ausführungsformen der erfindungsgemäßen Temperiereinrichtung können an die axiale Wand 30 eine Heizeinrichtung und/oder eine Kühleinrichtung thermisch leitend angeschlossen sein.

Die **Figuren 5a und 5b** zeigen jeweils das Temperaturprofil in der Probe längs der z-Achse, und zwar **Fig. 5a** bei einer Anordnung nach dem Stand der Technik und **Fig. 5b** bei einer erfindungsgemäß ausgestalteten Temperiereinrichtung. Schon der absolute Temperatur-Hub wird durch die Erfindung um eine ganze Größenordnung verringert, was zu entsprechend erhöhter Temperaturstabilität im NMR-Probenröhrchen wesentlich beiträgt. Zudem gelingt es mit der Erfindung, den Temperaturgradienten umzukehren.

Zusammenfassend beschreibt die vorliegende Erfindung Möglichkeiten zur Verbesserung der Temperierung (Kühlung oder Beheizung) eines NMR-Probenröhrchens, wobei durch einen Fluidstrom nach dem Gegenstromprinzip unmittelbar am Probenröhrchen ein möglichst geringer Temperaturgradient eingestellt wird. Ein wesentlicher Unterschied zum bekannten Stand der Technik liegt in der speziellen Art der Temperierung der den Innenraum 21 radial nach außen begrenzenden zylindrischen Wand 39, insbesondere durch eine Temperierung der den radial innersten Strömungskanal 31 in radialer Richtung nach außen begrenzenden axialen Wand 30.

Die Merkmale aller oben beschriebenen Ausführungsformen der Erfindung können -jedenfalls größtenteils- auch miteinander kombiniert werden, sofern hierdurch der durch die Ansprüche definierte Schutzbereich der Erfindung nicht verlassen wird.

## Referenzliste

[1] DE 10 2010 029 080 B4, US 8,847,595 B2
[2] DE 10 2012 217 601 B4, US 9,482,729 B2
[3] DE 40 18 734 C2, US 5,192,910 A

## Bezugszeichenliste:

| | |
|---|---|
| 20 | Temperiereinrichtung |
| 21 | Innenraum |
| 22 | NMR-Probenröhrchen |
| 23 | zweiter axialer Endbereich |
| 24 | Öffnung im oberen Abschlussstück |
| 25 | oberes Abschlussstück |
| 26 | erster axialer Endbereich |
| 27 | unteres Abschlussstück |
| 28 | radial äußerster Strömungskanal |
| 28a | äußere Abteilung |
| 28b | innere Abteilung |
| 28c | axiale Zwischenwand |
| 29 | radial äußere axiale Wand |
| 30 | radial innere axiale Wand |
| 31 | radial innerster Strömungskanal |
| 32 | Fluideinlass |
| 32' | erster Einlass in die äußere Abteilung |
| 32" | zweiter Einlass in die innere Abteilung |
| 33 | gemeinsamer Zulauf |
| 34 | erster Fluiddurchlass |
| 35 | Fluidauslass |
| 36 | zweiter Fluiddurchlass zum Innenraum |
| 37 | Ventileinrichtung |
| 39 | den Innenraum radial nach außen begrenzende zylindrische Wand |
| z | Längsachse des NMR-Probenröhrchens im NMR-Messbetrieb |

**Patentansprüche**

1. Temperiereinrichtung (20) für ein NMR-Probenröhrchen (22), wobei um einen von einer zylindrischen Wand (39) radial nach außen begrenzten Innenraum (21) zur Aufnahme des NMR-Probenröhrchens (22) mehrere ineinander angeordnete, radial um den Innenraum (21) herum verlaufende Strömungskanäle (28, 31) für temperierendes Fluid ausgebildet sind, von denen der radial äußerste Strömungskanal (28), welcher durch axiale Wände (29, 30) begrenzt ist, eine äußere Abteilung (28a) und eine innere Abteilung (28b) umfasst, die so ausgebildet sind, dass das temperierende Fluid in der äußeren und der inneren Abteilung im Betrieb in der gleichen Richtung strömt,

    wobei die Temperiereinrichtung (20) in einem ersten axialen Endbereich (26) geschlossen zum Innenraum (21) und in einem gegenüberliegenden zweiten axialen Endbereich (23) für das Einführen des NMR-Probenröhrchens (22) in den Innenraum (21) offen zum Innenraum (21) ausgebildet ist,
    wobei in einem Gegenstrombereich benachbarte Strömungskanäle (28, 31) jeweils mit einem ersten Fluiddurchlass (34) an einem axialen Ende so miteinander verbunden sind, dass sich die Strömungsrichtung eines Fluidstroms im radial äußersten Strömungskanal (28) zum benachbarten radial innersten Strömungskanal (31) im Gegenstrombereich umkehrt,
    wobei der radial äußerste Strömungskanal (28) an einem axialen Ende einen Fluideinlass (32) aufweist,
    und wobei der radial innerste Strömungskanal (31), welcher durch die axialen Wände (29, 39) begrenzt ist, an einem axialen Ende, das dem geschlossen ausgebildeten ersten axialen Endbereich (26) zugewandt ist, einen zweiten Fluiddurchlass (36) zum Innenraum (21) aufweist, **dadurch gekennzeichnet,**
    **dass** die äußere Abteilung (28a) des radial äußersten Strömungskanals (28) geometrisch so gestaltet ist, dass sie in flächigem thermischen Kontakt sowohl mit der radial inneren axialen Wand (30) als auch mit der radial äußeren axialen Wand (29) steht, dass die äußere Abteilung (28a) die innere Abteilung (28b) des radial äußersten Strömungskanals (28) derart umgibt, dass die innere Abteilung (28b) weder in thermischem Kontakt mit der radial inneren axialen Wand (30) noch mit der radial äußeren axialen Wand (29) steht, und dass die innere Abteilung (28b) des radial äußersten Strömungskanals (28) von einer axialen Zwischenwand (28c) begrenzt ist, welche sich ausgehend von dem geschlossen ausgebildeten ersten axialen Endbereich (26) nur so weit in axialer Richtung erstreckt, dass sie vom zweiten axialen Endbereich (23) axial beabstandet ist.

2. Temperiereinrichtung (20) nach Anspruch 1, **dadurch gekennzeichnet, dass** die äußere Abteilung (28a) des radial äußersten Strömungskanals (28) so ausgebildet ist, dass die Strömungsgeschwindigkeit des temperierenden Fluids durch die äußere Abteilung (28a) kleiner ist als durch die innere Abteilung (28b), vorzugsweise höchstens halb so groß, insbesondere mindestens zehnmal geringer, besonders bevorzugt, dass die Strömungsgeschwindigkeit des temperierenden Fluids durch die äußere Abteilung (28a) gegen Null geht.

3. Temperiereinrichtung (20) nach einem der Ansprüche 1 oder 2, **dadurch gekennzeichnet, dass** die äußere Abteilung (28a) des radial äußersten Strömungskanals (28) einen größeren Strömungsquerschnitt quer zur Strömungsrichtung des temperierenden Fluids aufweist als die innere Abteilung (28b), vorzugsweise einen mindestens doppelt so großen Strömungsquerschnitt, insbesondere mindestens den zehnfachen Strömungsquerschnitt.

4. Temperiereinrichtung (20) nach einem der vorhergehenden Ansprüche, **dadurch gekennzeichnet, dass** die äußere Abteilung (28a) und die innere Abteilung (28b) des radial äußersten Strömungskanals (28) so ausgestaltet sind, dass die mittlere Durchflussmenge an temperierendem Fluid durch die äußere Abteilung (28a) des radial äußersten Strömungskanals (28) kleiner ist als durch die innere Abteilung (28b), vorzugsweise höchstens halb so groß ist, insbesondere mindestens zehnmal geringer ist, besonders bevorzugt gegen Null geht.

5. Temperiereinrichtung (20) nach einem der vorhergehenden Ansprüche, **dadurch gekennzeichnet, dass** der Strömungskontakt zwischen der inneren Abteilung (28b) und der äußeren Abteilung (28a) des radial äußersten Strömungskanals (28) variabel eingestellt werden kann, wobei vorzugsweise die axiale Zwischenwand (28c), welche die innere Abteilung (28b) des radial äußersten Strömungskanals (28) begrenzt, Ausnehmungen aufweist, insbesondere in Form von variabel verschließbaren Löchern, durch die ein Strömungskontakt zwischen der inneren Abteilung (28b) und der äußeren Abteilung (28a) hergestellt werden kann.

6. Temperiereinrichtung (20) nach einem der vorhergehenden Ansprüche, **dadurch gekennzeichnet, dass** die axiale Zwischenwand (28c), welche die innere Abteilung (28b) des radial äußersten Strömungskanals (28) begrenzt, so ausgestaltet ist, dass sie eine thermische Isolation gegenüber der äußeren Abteilung (28a) bewirkt und einen Wärmedurchgangskoeffizienten von weniger als 4 W/(m²K) aufweist.

7. Temperiereinrichtung (20) nach einem der vorhergehenden Ansprüche, **dadurch gekennzeichnet, dass** die innere Abteilung (28b) des radial äußersten Strömungskanals (28) als Kapillare mit geschlossener Zwischenwand (28c), als Kapillar-Segment oder als vollständig radial umlaufender Kapillar-Kanal ausgebildet ist.

8. Temperiereinrichtung (20) nach einem der vorhergehenden Ansprüche, **dadurch gekennzeichnet, dass** der Fluideinlass (32) in mindestens zwei separate Einlässe (32', 32") aufgespalten ist, wobei der erste Einlass (32') in die äußere Abteilung (28a) des radial äußersten Strömungskanals (28), der zweite Einlass (32") in die innere Abteilung (28b) mündet und dass vorzugsweise die Durchflussmenge pro Zeiteinheit oder die Temperatur von temperierendem Fluid des durch den ersten Einlass (32') in die äußere Abteilung (28a) strömenden Fluids separat zu dem durch den zweiten Einlass (32") in die innere Abteilung (28b) strömenden Fluid geregelt werden kann.

9. Temperiereinrichtung (20) nach Anspruch 8, **dadurch gekennzeichnet, dass** eine Ventileinrichtung (37) zur Regelung der Fluidströme durch den ersten Einlass (32') und durch den zweiten Einlass (32") vorhanden ist.

**Claims**

1. A temperature control device (20) for an NMR sample tube (22), wherein, around an interior (21) delimited in a radially outward direction by a cylindrical wall (39), a plurality of flow channels (28, 31) for a temperature-controlling fluid arranged inside one another and running radially around the interior (21) are formed for receiving the NMR sample tube (22), of which the radially outermost flow channel (28), which is delimited by axial walls (29, 30), comprises an outer compartment (28a) and an inner compartment (28b), which are designed such that during operation, the temperature-controlling fluid flows in the same direction in the outer and the inner compartment,

    wherein the temperature control device (20) is formed in a first axial end region (26) such that it is closed to the interior (21) and in an opposite, second axial end region (23) such that it is open to the interior (21) for the introduction of the NMR sample tube (22) into the interior (21), wherein adjacent flow channels (28, 31) in a counterflow area are each connected to one another with a first fluid passage (34) at one axial end such that the flow direction of a fluid flow in the radially outermost flow channel (28) to the adjacent, radially innermost flow channel (31) reverses in the countercurrent area, wherein the radially outermost flow channel (28) comprises a fluid inlet (32) at one axial end, and wherein the radially innermost flow channel (31), which is delimited by the axial walls (29, 39), comprises a second fluid passage (36) to the interior (21) at an axial end which faces the closed first axial end region (26), **characterized in that** the outer compartment (28a) of the radially outermost flow channel (28) is geometrically designed in such a way that it is in flat thermal contact with both the radially inner axial wall (30) and the radially outer axial wall (29), that the outer compartment (28a) surrounds the inner compartment (28b) of the radially outermost flow channel (28) such that the inner compartment (28b) is neither in thermal contact with the radially inner axial wall (30) nor with the radially outer axial wall (29), and that the inner compartment (28b) of the radially outermost flow channel (28) is delimited by an axial partition (28c) which, starting from the closed first axial end region (26), extends only so far in the axial direction that it is axially spaced apart from the second axial end region (23).

2. The temperature control device (20) according to claim 1, **characterized in that** the outer compartment (28a) of the radially outermost flow channel (28) is designed so that the flow rate of the temperature-controlling fluid through the outer compartment (28a) is less than through the inner compartment (28b), preferably at most half as large, in particular at least ten times less, particularly preferred that the flow rate of the temperature-controlling fluid through the outer compartment (28a) reaches zero.

3. The temperature control device (20) according to one of claims 1 or 2, **characterized in that** the outer compartment (28a) of the radially outermost flow channel (28) has a larger flow cross section transversely to the flow direction of the temperature-controlling fluid than the inner compartment (28b), preferably at least twice as large a flow cross section, in particular at least ten times the flow cross-section.

4. The temperature control device (20) according to one of the preceding claims, **characterized in that** the outer compartment (28a) and the inner compartment (28b) of the radially outermost flow channel (28) are designed so that the average flow rate of temperature-controlling fluid through the outer compartment (28a) of the radially outermost flow channel (28) is smaller than through the inner compartment (28b), preferably at most half as large, in particular at least ten times less, particularly preferably reaching zero.

5. The temperature control device (20) according to one of the preceding claims, **characterized in that** the flow contact between the inner compartment (28b) and the outer compartment (28a) of the radially outermost flow channel (28) can be set variably, wherein preferably the axial partition (28c), which delimits the inner compartment (28b) of the radially outermost flow channel (28), has recesses, in particular in the form of variably closable holes through which flow contact can be established between the inner compartment (28b) and the outer compartment (28a).

6. The temperature control device (20) according to one of the preceding claims, **characterized in that** the axial partition (28c), which delimits the inner compartment (28b) of the radially outermost flow channel (28), is designed so that it provides thermal insulation from the outer compartment (28a) and has a heat transfer coefficient of less than 4 W/(m$^2$K).

7. The temperature control device (20) according to one of the preceding claims, **characterized in that** the inner compartment (28b) of the radially outermost flow channel (28) is designed as a capillary with a closed partition (28c), as a capillary segment or as a completely radially circumferential capillary channel.

8. The temperature control device (20) according to one of the preceding claims, **characterized in that** the fluid inlet (32) is split into at least two separate inlets (32', 32") wherein the first inlet (32') opens into the outer compartment (28a) of the radially outermost flow channel (28) and the second inlet (32") opens into the inner compartment (28b) and **in that**, preferably, the flow rate per unit of time or the temperature of the temperature-controlling fluid of the fluid flowing through the first inlet (32') into the outer compartment (28a) can be regulated separately from the fluid flowing through the second inlet (32") into the inner compartment (28b).

9. The temperature control device (20) according to claim 8, **characterized in that** a valve device (37) is provided for regulating the fluid flows through the first inlet (32') and through the second inlet (32").

**Revendications**

1. Dispositif (20) d'équilibrage thermique dévolu à une éprouvette (22) d'échantillonnage RMN, dans lequel, autour d'un espace interne (21) conçu pour recevoir ladite éprouvette (22) d'échantillonnage RMN et délimité par une paroi cylindrique (39), vers l'extérieur dans le sens radial, sont ménagés plusieurs canaux d'écoulement (28, 31) destinés à un fluide d'équilibrage de température, imbriqués les uns dans les autres et s'étendant radialement tout autour dudit espace interne (21), canaux au sein desquels le canal d'écoulement (28) radialement le plus extérieur, délimité par des parois axiales (29, 30), comprend un compartiment extérieur (28a) et un compartiment intérieur (28b) réalisés de façon telle que le fluide d'équilibrage de température circule, en service, dans la même direction dans lesdits compartiments extérieur et intérieur,

sachant que ledit dispositif (20) d'équilibrage thermique est de réalisation fermée vers l'espace interne (21), dans une première région extrême axiale (26), et de réalisation ouverte vers ledit espace interne (21) dans une seconde région extrême axiale (23), tournée à l'opposé et dédiée à l'insertion de l'éprouvette (22) d'échantillonnage RMN,
sachant que, dans une zone de circulation à contre-courant, des canaux d'écoulement voisins (28, 31) sont mutuellement raccordés, à chaque fois, par un premier passage (34) de fluide à une extrémité axiale, de telle sorte que, dans ladite zone de circulation à contre-courant, la direction de l'écoulement d'un flux de fluide, dans le canal d'écoulement (28) radialement le plus extérieur, s'inverse vers le canal d'écoulement (31) voisin, radialement le plus intérieur, ledit canal d'écoulement (28) radialement le plus extérieur étant muni d'une admission (32) de fluide, à une extrémité axiale,
et sachant que ledit canal d'écoulement (31) radialement le plus intérieur, délimité par les parois axiales (29, 30), est pourvu d'un second passage (36) de fluide gagnant l'espace interne (21), à une extrémité axiale tournée vers la première région extrême axiale (26) de réalisation fermée,
**caractérisé par le fait**
**que** le compartiment extérieur (28a) du canal d'écoulement (28) radialement le plus extérieur présente une configuration géométrique telle qu'il soit thermiquement en contact, à plat, tant avec la paroi axiale (30) radialement intérieure qu'avec la paroi axiale (29) radialement extérieure ;
par le fait que ledit compartiment extérieur (28a) entoure le compartiment intérieur (28b) dudit canal d'écoulement (28) radialement le plus extérieur, de telle sorte que ledit compartiment intérieur (28b) ne soit thermiquement en contact ni avec ladite paroi axiale (30) radialement intérieure, ni avec ladite paroi axiale (29) radialement extérieure ;

et par le fait que ledit compartiment intérieur (28b) dudit canal d'écoulement (28) radialement le plus extérieur est délimité par une paroi axiale intermédiaire (28c) qui s'étend dans la direction axiale, à partir de la première région extrême axiale (26) de réalisation fermée, uniquement d'une distance telle qu'elle soit axialement espacée de la seconde région extrême axiale (23).

**2.** Dispositif (20) d'équilibrage thermique selon la revendication 1, **caractérisé par le fait que** le compartiment extérieur (28a) du canal d'écoulement (28) radialement le plus extérieur est conçu de façon telle que la vitesse d'écoulement du fluide d'équilibrage de température parcourant ledit compartiment extérieur (28a) soit inférieure à celle parcourant le compartiment intérieur (28b), préférentiellement de moitié moindre au maximum, en particulier au moins dix fois moindre et, avec préférence particulière, de façon telle que ladite vitesse d'écoulement du fluide d'équilibrage de température parcourant ledit compartiment extérieur (28a) tende vers zéro.

**3.** Dispositif (20) d'équilibrage thermique selon l'une des revendications 1 ou 2, **caractérisé par le fait que** le compartiment extérieur (28a) du canal d'écoulement (28) radialement le plus extérieur présente, transversalement par rapport à la direction d'écoulement du fluide d'équilibrage de température, une section transversale d'écoulement supérieure à celle du compartiment intérieur (28b), de préférence une section transversale d'écoulement au moins égale au double, en particulier au moins au décuple de ladite section transversale d'écoulement.

**4.** Dispositif (20) d'équilibrage thermique selon l'une des revendications précédentes, **caractérisé par le fait que** le compartiment extérieur (28a) et le compartiment intérieur (28b) du canal d'écoulement (28) radialement le plus extérieur sont conçus de façon telle que le débit moyen de fluide d'équilibrage de température, parcourant ledit compartiment extérieur (28a) du canal d'écoulement (28) radialement le plus extérieur, soit inférieur à celui parcourant ledit compartiment intérieur (28b), préférentiellement inférieur de moitié au maximum, en particulier au moins dix fois moindre, et tende vers zéro avec préférence particulière.

**5.** Dispositif (20) d'équilibrage thermique selon l'une des revendications précédentes, **caractérisé par le fait que** le contact d'écoulement, entre le compartiment intérieur (28b) et le compartiment extérieur (28a) du canal d'écoulement (28) radialement le plus extérieur, peut être réglé de manière variable, sachant que la paroi axiale intermédiaire (28c) délimitant ledit compartiment intérieur (28b) du canal d'écoulement (28) radialement le plus extérieur comporte, de préférence, des évidements revêtant, en particulier, la forme de trous à faculté d'obturation variable par l'intermédiaire desquels un contact d'écoulement peut être établi entre ledit compartiment intérieur (28b) et ledit compartiment extérieur (28a).

**6.** Dispositif (20) d'équilibrage thermique selon l'une des revendications précédentes, **caractérisé par le fait que** la paroi axiale intermédiaire (28c), qui délimite le compartiment intérieur (28b) du canal d'écoulement (28) radialement le plus extérieur, est conçue de manière qu'elle instaure une isolation thermique vis-à-vis du compartiment extérieur (28a), et présente un coefficient de transfert de chaleur inférieur à 4 W/(m$^2$K).

**7.** Dispositif (20) d'équilibrage thermique selon l'une des revendications précédentes, **caractérisé par le fait que** le compartiment intérieur (28b) du canal d'écoulement (28) radialement le plus extérieur est réalisé sous la forme d'un capillaire à paroi intermédiaire (28c) fermée, d'un segment de capillaire, ou d'un canal capillaire à étendue périphérique intégrale dans le sens radial.

**8.** Dispositif (20) d'équilibrage thermique selon l'une des revendications précédentes, **caractérisé par le fait que** l'admission (32) du fluide est scindée en au moins deux admissions (32', 32") distinctes, sachant que la première admission (32') débouche dans le compartiment extérieur (28a) du canal d'écoulement (28) radialement le plus extérieur, la seconde admission (32") débouchant dans le compartiment intérieur (28b) ; et **par le fait que**, de préférence, le débit par unité de temps ou la température du fluide d'équilibrage de température affluant dans ledit compartiment extérieur (28a), en empruntant ladite première admission (32'), peut être régulé(e) distinctement de celui (celle) du fluide affluant dans ledit compartiment intérieur (28b) en empruntant ladite seconde admission (32").

**9.** Dispositif (20) d'équilibrage thermique selon la revendication 8, **caractérisé par** la présence d'un dispositif distributeur (37) affecté à la régulation des flux de fluide empruntant la première admission (32') et la seconde admission (32").

EP 3 881 088 B1

Fig.1

**Fig.2**

**Fig.3**

Fig. 4a

Fig. 4b

Fig. 4c

Fig. 5a

Fig. 5b

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102010029080 B4
- US 8847595 B2
- DE 102012217601 B4
- US 9482729 B2
- DE 4018734 C2
- US 5192910 A